# EUROPEAN PATENT APPLICATION

(11) **EP 1 944 807 A1**
(43) Date of publication of application: **16.07.2008**
(21) Application number: 07100471.7
(22) Date of filing: 12.01.2007
(51) Int. Cl.: H01L 27/146, H01L 31/0224, H01L 31/0216

(54) **Electromagnetic interference shielding for image sensor**

(71) Applicant: STMicroelectronics (Research & Development) Limited, Marlow, Buckinghamshire SL7 1YL (GB)
(72) Inventor: Dennis, Carl, Edinburgh, Lothian EH14 7HS (GB); Young, Peter, 33 Pinkhill Edinburgh, Lothian EH12 7BF (GB)
(74) Representative: Campbell, Arlene

(57) **Abstract**

An image sensing structure comprises an integral optically transparent conductive layer which provides EMI shielding. The solution is implemented at die level.
A substrate (30) is typically formed from silicon and comprises an active layer (32) which contains a number of doped regions for the collection and manipulation of photogenerated electrons. A layer of metal interconnects (34) is formed on the active layer (32), forming the pixel circuitry and for the transfer of charge from the die to the PCB. Next, a passivation layer (36) is formed. According to one embodiment, an additional optically transparent conductive layer (38) is formed prior to the colour filter array (40). In an alternative embodiment, the optically transparent conductive layer (38) can be formed after the colour filter array (40). The optically transparent conductive layer (38) is preferably formed from indium tin oxide (ITO), and has a thickness chosen to give a reduction of at least 10 dB in EMI emitted by the image sensing structure during operation.

## Description

The present invention relates to electromagnetic interference (EMI) shielding, in particular to EMI shielding for electronic devices.

During operation, all electronic devices radiate unwanted electrical signals known as EMI. In general, unwanted EMI can be dealt with in two ways: either by electrical or circuit level modifications or by physical shielding. Of course a combination of both types can be used for a particular device as appropriate.

Electrical techniques include modifying the timing of clock signals by frequency modulation so that the spectral density is reduced. This technique is also called clock skewing. This does not lessen the overall energy of the emitted EMI but it reduces unwanted peaks which would block frequency channels needed for data communication for example by radio transmitters used in a mobile telephone. At the circuit level, the length of path that could act as an aerial to transmit or receive EMI can be minimised. The effectiveness of this technique is necessarily limited by the need to use high frequency clocks and signalling. Other circuit techniques exist such as the introduction of lossy components and low impedance paths to ground to suppress noise.

Physical techniques predominately utilise shielding in the form of conductive layers or ground planes. The shields can act to absorb EMI, or simply to reflect it back into the body of the device, depending on the type and quantity of material that is used. Of course, for any particular device, a shield will have a mixture of absorption and reflection properties, but in general a shield can be designed to be thin and reflective, with a small absorption effect, or to be thicker and show a greater degree of absorption loss. A reflection of EMI back into the circuit producing it is possible with a continuous shield and is generally not a significant problem for the majority of devices, so it can be a preferred option when the thicker layers required to absorb the EMI are not practical. Of course, a physical shield will also protect the device from incident EMI as well as stopping radiation of EMI from the device. A low impedance connection between shield to ground is important to maximise shielding effectiveness.

Trends in the manufacture of electronic devices mean that EMI considerations are of increasing concern. For example, in the mobile telephone industry there is a strong desire to increase battery life, while providing multiple functions on one device. Accordingly, there is a tendency to use weaker strength antennas for the radio transmissions of data. The use of weaker antennas means that unwanted EMI has a greater effect on the signal quality for voice and data calls.

EMI is a problem in particular for devices such as mobile telephones whose components have high operating frequencies and include radio transmission elements. Furthermore, the majority of current mobile telephones include one or more digital image sensors, and so a portion of the telephone's casing must remain optically transparent so that light can be incident on an imaging portion of a solid state image sensor, usually via a lens or other optical suitable component. Thus, this portion of the camera casing cannot be shielded with the usual metals, such as copper, stainless steel, nickel, gold etc which do not permit the passage of light.

There are a small number of materials which are both conductive and optically transparent. One of the most common of these is indium tin oxide (ITO). It is known that ITO can be applied as a coating to the surface of a lens to mitigate EMI problems. However, direct application of this method with solid state image sensors causes problems. Firstly a lens is usually housed in a barrel within a camera module and so covering the lens itself still leaves gaps between the edge of the lens and the conductive inner edge of the module through which EMI can pass. Also, the conductive layer formed on the lens must be connected to ground, which in devices such as digital cameras in mobile telephones can be problematic because of the required rotary movement of the barrel for focusing and the extra tracking required.

Another type of image sensor technology uses a concept known as top surface imaging, in which an uppermost conductive layer was used as the active layer. This topmost active layer was known to be formed from ITO. The topmost ITO layer was the material used for the formation of the pixel's active elements, including the photodiode portions.

According to a first aspect of the present invention there is provided an image sensing structure comprising a semiconductor substrate having doped regions formed therein for the collection of photogenerated charge; and
an optically transparent conductive EMI shield layer,
with a passivation layer interposed therebetween.

Preferably, the image sensing structure further comprises a metal interconnect layer between the semiconductor substrate and the passivation layer.

Preferably, the image sensing structure further comprises a colour filter array formed over or under the EMI shield layer.

Preferably, said optically transparent conductive EMI shield layer is formed from indium tin oxide (ITO).

Preferably, the EMI shield layer has a thickness chosen to give a reduction of at least 10dB in EMI emitted by the image sensing structure during operation.

Preferably, the EMI shield layer has a thickness of between 50nm and 250nm, most preferably approximately 100nm.

Preferably, the EMI shield layer is patterned to provide a connection with the imaging die wire bonds for conducting EMI to ground.

According to a second aspect of the present invention there is provided a camera module comprising the image sensing structure of the first aspect.

The camera module preferably comprises EMI shielding on an outer surface thereof, and also preferably comprises an optical component coated with an optically transparent conductive EMI shield layer.

According to further aspects there are provided a mobile telephone, digital still camera, optical pointing device webcam or barcode reader comprising the image sensing structure of the first aspect and/or the camera module of the second aspect.

The present invention will now be described, by way of example only, with reference to the accompanying drawings, in which:
- Fig. 1: shows the structure of an image sensor and camera module; and
- Fig. 2: shows a die level cross-section showing an embodiment of the invention.

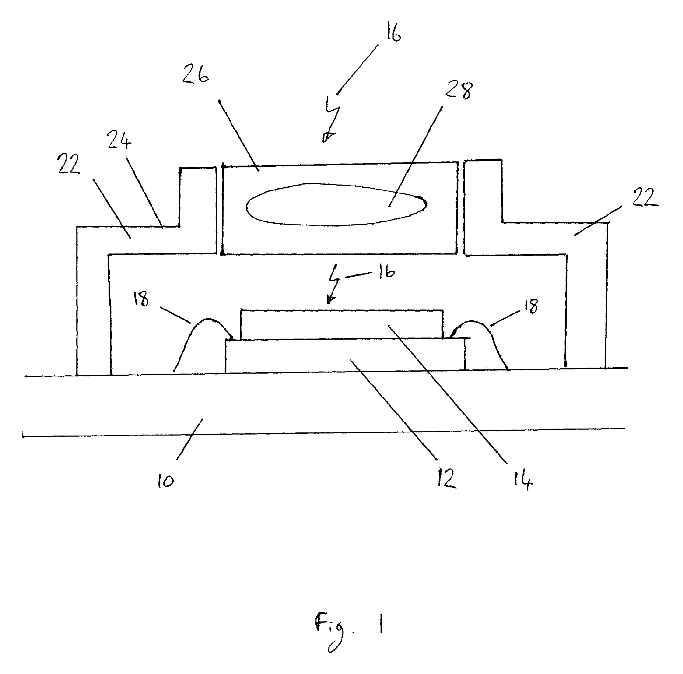

Figure 1 shows a typical structure for an image sensor. Selective components are shown for ease of illustration in the present application and it is to be understood that other components could be incorporated into the structure. A substrate 10 is provided upon which an imaging die 12 is assembled. The substrate could be a PCB, ceramic or other materials. The imaging die 12 comprises a photosensitive portion 14 which collects incident light 16. Bond wires 18 are provided for forming electrical connections with the substrate 10. A number of gates 20 are formed within the body of the substrate 12. The gates 20 control the image sensing and readout operations and are required to switch at high speed, generating EMI in the process. For example, for a two Megapixel array to be driven at 30 frames per second the gates must operate at a frequency of 640 MHz with 10-bit serial data. The image sensing structure is provided within a mount 22 which is provided with a plating 24 for EMI shielding. The plating is typically made of copper within an overlaid stainless steel layer 24. To provide a reflective EMI shielding the plating typically has a thickness of 1-2 µm. However if it is to absorb the EMI it typically has a thickness of 10 µm or so. Reflective shielding is the type normally relied upon in such camera modules. The central aperture of the mount 22 comprises a lens housing 26 and lens 28 for focussing incident light 16 on to the photo sensitive portion 14 of the image sensor.

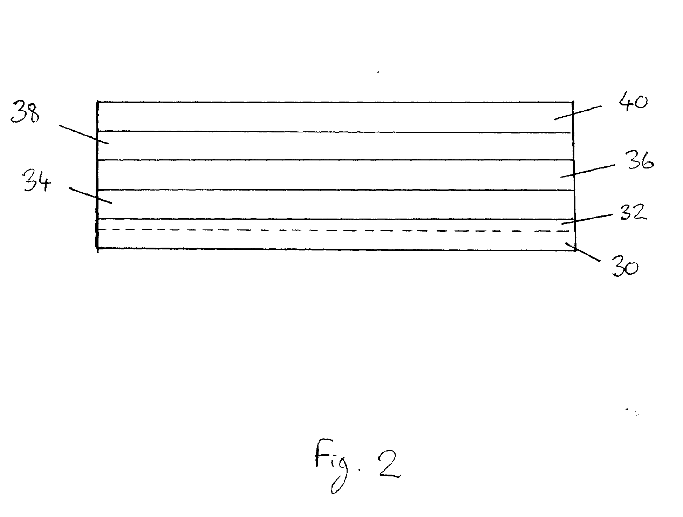

Figure 2 shows the solution at die level. A substrate 30 is typically formed from silicon, although other semiconductor materials may of course be used depending on the application. The substrate 30 comprises an active layer 32 which contains a number of doped regions for the collection and manipulation of photogenerated electrons in a well known manner. A layer of metal interconnects 34 is formed on the active layer 32, forming the pixel circuitry and for the transfer of charge from the die to the PCB (10 in Fig. 1). Next a passivation layer 36 is formed. In a normal process, a colour filter array 40 is formed on the passivation layer. However, according to one embodiment, an additional optically transparent conductive layer 38 is formed prior to the colour filter array 40. In an alternative embodiment, the optically transparent conductive layer 38 can be formed after the colour filter array 40.

The optically transparent conductive layer 38 is preferably formed from indium tin oxide (ITO), and has a thickness chosen to give a reduction of at least 10dB in EMI emitted by the image sensing structure during operation. For example, for a particular case, calculations show a 40dB plane wave (which could be incident external radiation), 100dB E-field reflection (the internal or external source), and a 10dB H-field (the internal source). These figures do not include coupling/crosstalk effects, which will negate shielding effects somewhat, but it is expected that at least a 10dB reduction can be obtained.

A thickness that gives this effect may therefore be between 50nm and 250nm, most preferably about 100nm (0.1µm).

The ITO layer 38 should have a low impedance connection to ground so that its EMI shielding effects are fully enhanced. In one optional further amendment this is achieved by patterning it so that it connects up with parts of the die, , for example to the wire bonds, to transfer charge

The ITO layer can be formed using standard PECVD (Plasma Enhanced Chemical Vapour Deposition) techniques, and so only a simple modification to standard CMOS manufacturing techniques is needed.

It will be appreciated that this layer of ITO will reduce the EMI emissions from the device and it will also provide a degree of protection for the active layer of the silicon from incident EMI.

The shield layer has never been formed at the actual die level before, it has only been applied to external devices such as lenses which are outside the die.

The optically transparent conductive material will of course reduce the optical transmission - the amount of this reduction will depend on the type and thickness of the layer that is chosen. However, when ITO is used it is expected that the level of transmission can be 95% or greater.

The levels of noise reduction that can be achieved depend on the wave equations and also on the cross talk of circuit components. Reflection is significant in the near-field due to the large mismatch between wave and conductor impedance, but mutual inductance and capacitance between circuit and conductive layer does limit the effect. At present the noise reduction can be observed to be at least a few decibels.

It will be appreciated that the invention has use for any semiconductor device and is not limited to the field of image sensors, and within the field of image sensors it has applicability to both CMOS and CCD sensors, for use with mobile devices including mobile telephones and personal digital assistants, standalone digital still cameras, webcams, optical mice, barcode readers and so on.

Various improvements and modifications may be made to the above without departing from the scope of the present invention.

## Claims

1. An image sensing structure comprising a semiconductor substrate having doped regions formed therein for the collection of photogenerated charge; and
an optically transparent conductive EMI shield layer,
with a passivation layer interposed therebetween.

2. The image sensing structure of claim 1, further comprising a metal interconnect layer between the semiconductor substrate and the passivation layer.

3. The image sensing structure of claim 1 or claim 2, further comprising a colour filter array formed over or under the EMI shield layer.

4. The image sensing structure of any preceding claim, **characterised in that** said optically transparent conductive EMI shield layer is formed from indium tin oxide (ITO).

5. The image sensing structure of any preceding claim, wherein the EMI shield layer has a thickness chosen to give a reduction of at least 10dB in EMI emitted by the image sensing structure during operation.

6. The image sensing structure of any preceding claim, wherein the EMI shield layer has a thickness of between 50nm and 250nm, most preferably approximately 100nm.

7. The image sensing structure of any preceding claim, wherein the EMI shield layer is patterned to provide a connection with the imaging die wire bonds for conducting EMI to ground.

8. A camera module comprising the image sensing structure of any preceding claim.

9. The camera module of claim 8, comprising EMI shielding on an outer surface thereof.

10. The camera module of claim 9, comprising an optical component coated with an optically transparent conductive EMI shield layer.

11. A mobile telephone comprising the image sensing structure of any of claims 1 to 7 and/or camera module of any of claims 8 to 10.

12. A digital still camera comprising the image sensing structure of any of claims 1 to 7 and/or camera module of any of claims 8 to 10.

13. An optical pointing device comprising the image sensing structure of any of claims 1 to 7 and/or camera module of any of claims 8 to 10.

14. A webcam comprising the image sensing structure of any of claims 1 to 7 and/or camera module of any of claims 8 to 10.

15. A barcode reader comprising the image sensing structure of any of claims 1 to 7 and/or camera module of any of claims 8 to 10.
